# EUROPÄISCHE PATENTSCHRIFT

(11) **EP 4 053 569 B1**
(45) Veröffentlichungstag und Bekanntmachung des Hinweises auf die Patenterteilung: **27.09.2023**
(21) Anmeldenummer: 21160897.1
(22) Anmeldetag: 05.03.2021
(51) Int. Cl.: G01R 23/02

(54) **VERFAHREN UND SYSTEM ZUM AUSWERTEN EINER EINGANGSSPANNUNG EINER STROMVERSORGUNG**
METHOD AND SYSTEM FOR EVALUATING AN INPUT VOLTAGE OF A POWER SUPPLY
PROCÉDÉ ET SYSTÈME D'ÉVALUATION D'UNE TENSION D'ENTRÉE D'UNE ALIMENTATION ÉLECTRIQUE

(43) Veröffentlichungstag der Anmeldung: 07.09.2022
(73) Patentinhaber: Siemens Aktiengesellschaft, 80333 München (DE)
(72) Erfinder: Hörist, Gerald, 1220 Wien (AT)
(74) Vertreter: Siemens Patent Attorneys

(56) Entgegenhaltungen:
- EP-A1- 1 789 810
- DE-T2- 3 852 556
- KR-A- 20150 108 133
- US-A- 4 494 067
- US-A1- 2016 126 825
- US-A1- 2017 336 448
- US-B1- 7 266 465
- US-B1- 10 110 246

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf ein Verfahren zum Auswerten einer Eingangsspannung einer Stromversorgung bzw. eines Schaltnetzteils, wobei die Eingangsspannung eine eindeutige Polarität aufweist. Weiterhin betrifft die vorliegende Erfindung ein System zur Durchführung des Verfahrens zum Auswerten der Eingangsspannung des Schaltnetzteils.

### Stand der Technik

In der Fertigungs- und Automatisierungstechnik werden in gro-βem Umfang Stromversorgungen bzw. Schaltnetzteile für eine Versorgung von Verbrauchern wie z.B. elektronische Steuerungen, Pumpen, Ventilen, Sensoren, etc. eingesetzt. Diese Verbraucher werden von der Stromversorgung bzw. dem Schaltnetzteil mit einer geeigneten, oft vordefinierten Spannung versorgt. Häufig wird dazu ein auf einer Eingangsseite des Schaltnetzteils hohes Spannungsniveau auf ein für die Verbraucher vordefiniertes, niedrigeres und üblicherweise konstantes Spannungsniveau auf einer Ausgangsseite des Schaltnetzteils umgesetzt.

Die Stromversorgung des Schaltnetzteils erfolgt üblicherweise mit einer Netzspannung aus einem einphasigen oder dreiphasigen Versorgungsnetz als Versorgungsspannung. Bei einer einphasigen oder dreiphasigen Netzspannung (z.B. 230V-Wechselspannung, Dreiphasenwechselspannung) als Versorgungsspannung weist das Schaltnetzteil häufig eine Eingangsstufe - beispielsweise in Form einer Gleichrichtereinheit - auf, durch welche die Wechselspannung aus dem Versorgungsnetz in eine sich zeitlich verändernde, meist pulsierende Gleichspannung als Eingangsspannung für das Schaltnetzteil umgewandelt wird. D.h. nach der Eingangsstufe bzw. nach der Gleichrichtereinheit liegt üblicherweise ein Eingangsspannung vor, welche eine eindeutige Polarität (d.h. die Polarität der Eingangsspannung bleibt über die Zeit gleich bzw. wechselt nicht) aufweist, deren Amplitude allerdings sich zeitlich verändert bzw. zeitlichen Schwankungen unterworfen ist. Von der Stromversorgung bzw. dem Schaltnetzteil wird dann die diese Eingangsspannung in eine konstante Ausgangsspannung für die elektrischen Verbraucher umgesetzt, wobei eine Konstanz der Ausgangsspannung und/oder eines Ausgangsstroms durch eine Regelung des Energieflusses erreicht wird.

Für Schaltnetzteile wird es heutzutage immer wichtiger die Netzverhältnisse - wie z.B. Netzfrequenz, Netzspannung, etc. - und auch Störungen im Versorgungsnetz (z.B. Phasenausfall bei einer dreiphasigen Versorgungsspannung, Überspannungsimpuls bzw. Surge, etc.) zu erkennen. Da Schaltnetzteile beispielsweise nur in einem gewissen Bereich der Eingangsspannung optimal arbeiten können, ist es wichtig die Netzverhältnisse zu kennen, um bei Abweichungen von einem optimalen Eingangsspannungsbereich Maßnahmen treffen zu können. Insbesondere eine eingangsseitigen Unterspannung bzw. eine Unterspannung aus dem Versorgungsnetz kann z.B. wegen der Konstanz der Ausgangsspannung des Schaltnetzteils zu einem Anstieg des Eingangsstroms führen. Dies kann z.B. zur Erwärmung der Bauteile des Schaltnetzteils oder sogar zu einer Beschädigung führen. Daher wird üblicherweise aus Sicherheitsgründen die Versorgungsspannung bzw. die Eingangsspannung überwacht und gegebenenfalls der Ausgang des Schaltnetzteils abgeschaltet, wenn z.B. ein vorgegebener Wert unterschritten wird. Um ein Überhitzen bzw. eine Beschädigung des Schaltnetzteils aufgrund einer eingangsseitigen Unterspannung bzw. einer Unterspannung aus dem Versorgungsnetz zu verhindern, ist eine laufende und möglichst genaue Überwachung der Eingangsspannung des Schaltnetzteils notwendig, um gegebenenfalls Maßnahmen (z.B. Abschalten des Ausgangs des Schaltnetzteils, etc.) zu setzen. Dabei können insbesondere eine Frequenz der zeitlichen Amplitudenänderung der Eingangsspannung des Schaltnetzteils bzw. eines Wechselspannungsanteils der Eingangsspannung des Schaltnetzteils sowie Schwankungen in der Amplitude der Eingangsspannung, etc. ermittelt werden.

Eine gängige Variante zur Frequenz- und Spannungsmessung stellt z.B. die Fourier-Analyse dar. Die Fourier-Analyse wird vor allem verwendet, um zeitlich sich verändernde bzw. periodische Signale in eine Summe von Sinusfunktionen mit unterschiedlichen Frequenzen und Amplituden zu zerlegen. Wird bei der Fourier-Analyse von einer Nicht-Sinusschwingung ausgegangen, so können durch die Fourier-Analyse z.B. die beteiligten Oberschwingungen ermittelt werden. D.h. bei einer gleichgerichteten Wechselspannung als Eingangsspannung kann durch die Fourier-Analyse beispielsweise der Wechselspannungsanteil, insbesondere die Frequenz des Wechselspannungsanteils, bestimmt werden. Weiterhin besteht durch eine Fourier-Analyse z.B. auch die Möglichkeit, Störungen der Netzspannung zu erkennen. Um die Eingangsspannung eines Schaltnetzteils mittels einer Fourier-Analyse auszuwerten, ist es allerdings notwendig, dass z.B. ein entsprechendes Messgerät bzw. eine entsprechende Logik vorgesehen ist, von welchen die Fourier-Analyse durchgeführt wird. Dies führt beispielsweise zu zusätzlichem Hardwareaufwand und/oder Speicherbedarf für einen entsprechenden Rechenalgorithmus.

Eine weitere Möglichkeit einer Frequenz- und Spannungsmessung bei einer Eingangsspannung eines Schaltnetzteils durchzuführen, stellt beispielsweise eine Zeitmessung zwischen zwei vorgegebenen bzw. fixen Punkten der Eingangsspannung dar. Aus der Zeitdauer zwischen den beiden vorgegebenen Punkten der Eingangsspannung kann dann beispielsweise eine Frequenz der zeitlichen Veränderung der Amplitude der Eingangsspannung des Schaltnetzteils abgeleitet werden. Dazu ist es allerdings notwendig, dass z.B. mittels einer zusätzlichen Messeinrichtung die Zeitdauer zwischen den vorgegebenen Punkten gemessen wird und die entsprechenden Punkte der Eingangsspannung entsprechend vorab definiert werden können. D.h. ein ungefährerer, zeitlicher Verlauf der Eingangsspannung sollte für die Vorgabe der fixen Messpunkte bekannt sein, da sonst die Ableitung der Frequenz eventuell sehr ungenau bzw. fehlerhaft sein kann.

Weiterhin ist aus der bisher unveröffentlichten europäischen Patentanmeldung Nr. 19205873.3 der Anmelderin ist beispielsweise eine Schaltungsanordnung sowie ein Verfahren bekannt, mit welchen eine Eingangsspannung einer Stromversorgung ausgewertet werden kann. Dabei werden aus der Versorgungsspannung der Stromversorgung bzw. des Schaltnetzteils mittels einer analogen Schaltungsanordnung zwei Ausgangssignale abgeleitet, aus welchen ein Messwert der Versorgungsspannung (z.B. Mittelwert) sowie eine Spannungsart der Versorgungsspannung (z.B. Gleichspannung oder Wechselspannung) abgeleitet werden können. Diese Schaltungsanordnung und vor allem das zugehörige Verfahren weisen allerdings den Nachteil auf, dass sie vor allem für die Auswertung einer Versorgungsspannung von einphasigen Stromversorgungen anwendbar sind. Weiterhin bedarf die Auswertung der Versorgungs- bzw. Eingangsspannung des Schaltnetzteils einer zusätzlichen Schaltungsanordnung und ist daher mit zusätzlichem Aufwand verbunden. Weiterhin kann mit der Schaltungsanordnung bzw. dem zugehörigen Verfahren nur die Spannungsart der Versorgungsspannung des Schaltnetzteils abgeleitet werden. D.h. das Verfahren erkennt nur, ob es sich bei der Versorgungsspannung um eine Gleichspannung oder eine einphasige Wechselspannung handelt, eine Frequenz der Versorgungsspannung kann nur grob abgeschätzt werden. Eine genaue Auswertung einer Eingangsspannung eines Schaltnetzteils, insbesondere einer gleichgerichteten, dreiphasigen Versorgungsspannung, ist mit der Schaltungsanordnung bzw. dem zugehörigen Verfahren nicht möglich. Weiterer relevanter Stand der Technik ist in den Druckschriften US 2017/336448 A1, US 2016/126825 A1 offenbart.

### Darstellung der Erfindung

Der Erfindung liegt daher die Aufgabe zugrunde, ein Verfahren sowie ein System zum Auswerten einer Eingangsspannung eines Schaltnetzteils anzugeben, welche auf einfache und kostengünstige Weise ohne großen Aufwand eine genaue Auswertung einer Eingangsspannung mit eindeutiger Polarität und zeitlich veränderlicher Amplitude ermöglichen.

Diese Aufgabe wird durch ein Verfahren gemäß eingangs angeführter Art sowie durch ein System zur Durchführung des Verfahrens mit den Merkmalen gemäß den unabhängigen Patentansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zum Auswerten einer Eingangsspannung einer Stromversorgung bzw. eines Schaltnetzteils. Dabei weist die auszuwertende Eingangsspannung eine eindeutige Polarität auf. D.h. die Eingangsspannung des Schaltnetzteils weist zwar zeitliche Veränderungen in ihrer Amplitude auf, die Polarität bleibt aber über die Zeit gleich bzw. ändert sich nicht - wie z.B. bei einer zeitlich schwankenden Gleichspannung oder einer gleichgerichteten ein- oder dreiphasigen Wechselspannung bzw. einer so genannten pulsierenden Gleichspannung. Die Eingangsspannung wird mittels Abtastung mit einer vorgegebenen Abtastrate abgetastet bzw. digitalisiert. Dabei weist die Abtastrate bzw. der Abtasttakt eine Periodendauer auf, welche wesentlich kürzer ist als eine Periodendauer einer zu erwartenden Frequenz des Wechselspannungsanteils bzw. Rippels der Eingangsspannung bzw. dass der Abtasttakt eine wesentlich höhere Frequenz hat als eine zu erwartende Frequenz der Wechselspannungsanteile bzw. des Rippels der auszuwertenden Eingangsspannung. Die digitalisierte Eingangsspannung wird dann einer Filtereinheit als Eingangssignal zugeführt und von der Filtereinheit derart gefiltert, dass ein Ausgangssignal der Filtereinheit dem Eingangssignal der Filtereinheit nacheilt.

Das bedeutet, dass das Ausgangssignal der Filtereinheit auf einem Abtastwert der digitalisierten Eingangsspannung basiert, welcher zeitlich gesehen vor einem Abtastwert der digitalisierten Eingangsspannung liegt, auf welchem das Eingangssignal der Filtereinheit basiert. D.h. die Filtereinheit bewirkt z.B. aufgrund ihrer Ausgestaltung zumindest eine Zeitverzögerung zwischen Eingangs- und Ausgangssignal. Eingangs- und Ausgangssignal der Filtereinheit werden dann mittels einer Komparatoreinheit verglichen. Die Vergleichsergebnisse, welche von der Komparatoreinheit als Ausgangssignal geliefert werden, werden in der Folge ausgewertet. Dabei werden während einer Auswerteperiode, welche durch Rücksetzen einer Zählereinheit gestartet wird, solange die von der Komparatoreinheit gelieferten Vergleichsergebnisse ausgewertet, bis nach einer ersten Zustandsänderung eines Vergleichsergebnisses eine weitere Zustandsänderung eines Vergleichsergebnisses festgestellt wird. D.h., dass die Auswertung der Vergleichsergebnisse solange fortgesetzt wird, bis nach einer ersten Änderung eines Wertes oder Zustands am Ausgang der Komparatoreinheit eine neuerliche Änderung des Wertes oder Zustands am Ausgang der Komparatoreinheit festgestellt wird. Dann wird die jeweilige Auswerteperiode beendet und in der Folge anhand eines aktuellen Zählerwerts der Zählereinheit eine Periodendauer und/oder eine Frequenz eines Wechselspannungsanteils der Eingangsspannung ermittelt.

Der Hauptaspekt der vorliegenden Erfindung besteht darin, dass für eine Realisierung ein geringer Aufwand an Bauteilen und/oder Speicherbedarf besteht. Es kann beispielsweise sehr einfach bereits vorhandene Hardware, wie z.B. eine Steuer- und/oder Regeleinheit des Schaltnetzteils für eine Realisierung des erfindungsgemäßen Verfahrens genutzt werden. Weiterhin kann mit dem Verfahren auf sehr einfache Weise eine Frequenz des Wechselspannungsanteils der Eingangsspannung des Schaltnetzteils ermittelt werden, um qualifizierte Aussagen über z.B. Störungen, Phasenausfall, etc. einer Versorgungsspannung des Schaltnetzteils machen und entsprechende Maßnahmen treffen zu können. Weiterhin kann sich das Verfahren - insbesondere das Eingangssignal bzw. die digitalisierte Spannung am Eingang der Filtereinheit und das Ausgangssignal der Filtereinheit, welche für die Frequenzbestimmung verglichen werden, fast automatisch an zeitliche Veränderungen der Eingangsspannungen anpassen, da die Filtereinheit derart ausgestaltet ist, dass das Ausgangssignal der Filtereinheit nacheilend gegenüber dem Eingangssignal der Filtereinheit ist. D.h., durch die Filterung erfährt das Ausgangssignal der Filtereinheit zumindest eine zeitliche Verzögerung gegenüber der digitalisierte Eingangsspannung, welche das Eingangssignal der Filtereinheit bildet. Weiterhin kann das Verfahren über große Eingangsspannungsbereiche genutzt werden, da für eine Auswertung keine Vorgabe von z.B. Schwellwerten notwendig ist, sondern sich das Verfahren automatisch und dynamisch an unterschiedliche Eingangsspannungsbereich eines Schaltnetzteils anpassen kann.

Weiterhin ist es günstig, wenn für eine Ermittlung eines Mittelwerts der Eingangsspannung eine Summenwert der über die jeweilige Auswerteperiode aufsummierten, digitalisierten Eingangsspannung sowie der aktuelle Zählerwert an einem Ende der jeweiligen Auswerteperiode herangezogen werden. Auf Basis des über die jeweilige Auswerteperiode ermittelten Summenwerts kann sehr einfach ein Mittelwert der Eingangsspannung berechnet werden, indem der Summenwert durch den aktuellen Zählerwert, welcher am Ende der jeweiligen Auswerteperiode aus der Zählereinheit abgefragt wird, dividiert wird. Für den Summenwert werden über die Abtastperiode mit der Abtastrate die Abtastwerte der digitalisierten Eingangsspannung aufsummiert.

Es ist auch von Vorteil, wenn während einer jeweiligen Auswerteperiode ein Minimalwert und ein Maximalwert der digitalisierten Eingangsspannung detektiert werden. Anhand des während einer jeweiligen Auswerteperiode detektierten Minimal- und Maximalwerts kann sehr einfach festgestellt werden, ob es sich bei einem vermeintlichen Nutzsignal z.B. um Rauschen handelt. Für eine sinnvolle Auswertung der Eingangsspannung ist es beispielweise wichtig, dass eine Differenz aus Minimal- und Maximalwert einer jeweiligen Auswerteperiode einen vorgebbaren Mindestwert überschreitet, um eine ungestörte Auswertung durchführen zu können.

Idealerweise wird die Eingangsspannung vor der Abtastung auf einen für eine Signalverarbeitung geeigneten Spannungsbereich reduziert. Bei Schaltnetzteilen, welche beispielsweise von einer einphasigen oder dreiphasigen Netzspannung versorgt werden, kann die gleichgerichtete Eingangsspannung in einem Bereich von ca. 550 Volt liegen. Um einen z.B. für einen Analog-Digitalwandler und/oder Mikrocontroller verarbeitbaren Eingangsspannungsbereich zu erzielen, ist es sinnvoll, die Eingangsspannung auf einen Spannungsbereich von ca. 3 Volt für eine Signalverarbeitung zu reduzieren.

Ein vorteilhafte Ausführungsvariante der Erfindung sieht vor, dass von der Komparatoreinheit beim Vergleichen des Eingangssignals der Filtereinheit mit dem Ausgangssignal der Filtereinheit eine Hysterese verwendet wird. Durch die Verwendung einer Hysterese beim Vergleich von Eingangs- und Ausgangssignal der Filtereinheit wird auf sehr einfache Weise eine Störungssicherheit erhöht. Durch die Hysterese können beispielsweise Fehlmessungen aufgrund eines etwaiges Signalrauschen sehr leicht verhindert werden.

Weiterhin ist es vorteilhaft, wenn bei Erreichen eines vorgegebenen maximalen Zählerwerts der Zählereinheit ein Auswerten des Vergleichsergebnisses der Komparatoreinheit beendet wird. Wird während einer Auswerteperiode bei der Auswertung der Vergleichsergebnisse der Komparatoreinheit beispielsweise keine erster und/oder keine weitere Zustandsänderung festgestellt, so kann durch Erreichen bzw. Überschreiten des vorgegebenen Zählerwerts der Zählereinheit die Auswertung der Vergleichsergebnisse sehr einfach z.B. mittels so genannten Timeout beendet werden. Die Zählereinheit kann dann beispielsweise für eine neuerlicher Auswerteperiode zurückgesetzt werden. Durch das Erreichen bzw. Überschreiten des vorgegebenen Zählerwerts durch die Zählereinheit kann beispielsweise auch festgestellt werden, dass z.B. einen sich kaum verändernde Gleichspannung als Eingangsspannung des Schaltnetzteils vorliegt. Als vorgegebener Zählerwert wird beispielsweise ein Zählerwert gewählt, welcher einer deutlich längeren Periodendauer entspricht als eine Periodendauer der niedrigsten, zu erwartenden Frequenz des Wechselanteils der auszuwertenden Eingangsspannung.

Es ist weiterhin vorteilhaft, wenn nach einer Digitalisierung bzw. nach der Abtastung der Eingangsspannung eine Rauschunterdrückung und/oder Rauschreduktion durchgeführt wird. Dadurch wird z.B. ein unerwünschtes Rauschen im digitalisierten Signal der Eingangsspannung bzw. in der digitalisierten Eingangsspannung reduziert bzw. verhindert und damit ein verbessertes und genaueres Auswertungsergebnis erzielt.

Die Lösung der Aufgabe erfolgt auch durch ein System zum Auswerten einer Eingangsspannung eines Schaltnetzteils, wobei die Eingangsspannung eine vorgegebene Polarität aufweist. Das System zur Durchführung des erfindungsgemäßen Verfahrens weist dabei zumindest folgende Funktionseinheiten auf:
- einen Analog-Digitalwandler zum Digitalisieren der Eingangsspannung, wobei die Eingangsspannung mit einer vorgegebenen Abtastrate abgetastet wird;
- zumindest eine Filtereinheit zum Filtern der digitalisierten Eingangsspannung, wobei die Filtereinheit derart ausgestaltet ist, dass ein Ausgangssignal der Filtereinheit dem Eingangssignal der Filtereinheit nacheilend ist;
- eine Komparatoreinheit zum Vergleichen des Eingangssignals der Filtereinheit mit dem Ausgangssignal der Filtereinheit;
- eine Zählereinheit zum Messen einer jeweiligen Auswerteperiode, welche zu Beginn der jeweiligen Auswerteperiode rücksetzbar ist;
- eine Ablaufsteuerung, welche als Zustandsmaschine ausgeführt ist und dazu eingerichtet ist:
   o eine jeweilige Auswerteperiode durch Rücksetzen zumindest der Zählereinheit zu starten;
   o Vergleichsergebnisse, welches von der Komparatoreinheit als Ausgangssignal geliefert werden, solange auszuwerten, bis nach einer ersten Zustandsänderung der Vergleichsergebnisse eine weitere Zustandsänderung der Vergleichsergebnisse festgestellt wird;
   o eine jeweilige Auswerteperiode nach dem weiteren Ausgangszustandswechsel der Komparatoreinheit zu beenden und zumindest einen aktuellen Zählerwert der Zählereinheit abzufragen, um eine Periodendauer und/oder eine Frequenz eines Wechselspannungsanteils der Eingangsspannung zu ermitteln; und
- eine Timereinheit, welche durch ein Taktsignal eine zeitliche Steuerung sowie die Abtastrate des Analog-Digitalwandlers vorgibt.

Der Vorteil des vorgeschlagenen Systems besteht darin, dass das System sehr einfach und ohne großen Aufwand (z.B. zusätzliche Bauteile, Speicherbedarf) für ein Schaltnetzteil realisiert werden kann. Mit dem System kann damit auf einfache Weise die Eingangsspannung eines Schaltnetzteils, insbesondere eine Frequenz des Wechselspannungsanteils, ausgewertet werden. Auf diese Weise können rasch und einfach Störungen der Versorgungsspannung des Schaltnetzteils - wie z.B. ein Phasenausfall bei einer dreiphasigen Versorgungsspannung - erkannt werden. Damit können z.B. rasch Maßnahmen getroffen werden und z.B. ein Betreiber über eine Störung informiert werden.

Es ist weiterhin vorteilhaft, wenn eine Integratoreinheit zum Aufsummieren der digitalisierten Eingangsspannung über die jeweilige Auswerteperiode vorgesehen ist, wobei die Integratoreinheit am Beginn der jeweiligen Auswerteperiode rücksetzbar ist. Mit Hilfe der Integratoreinheit können die Abtastwerte der digitalisierten Eingangsspannung sehr einfach über die Auswerteperiode z.B. im Abtasttakt aufsummiert werden. Ein Summenwert der Integratoreinheit kann dann am Ende der Auswerteperiode von der Ablaufsteuerung abgefragt werden und daraus z.B. ein Mittelwert der Eingangsspannung des Schaltnetzteils unter Verwendung des Zählerwerts am Ende der Auswerteperiode ermittelt werden. Die Kenntnis des Mittelwerts der Eingangsspannung hat den Vorteil, dass erkannt werden kann, ob das Schaltnetzteil beispielsweise in einem optimalen Spannungsbereich arbeitet oder ob Abweichungen vorliegen und entsprechende Maßnahmen getroffen werden müssen.

Idealerweise ist auch eine Detektoreinheit zum Detektieren von Spitzenwerten der digitalisierten Eingangsspannung während der jeweiligen Auswerteperiode vorgesehen, wobei die Detektoreinheit am Beginn der jeweiligen Auswerteperiode rücksetzbar ist. Durch die Detektoreinheit können auf einfache Weise ein Minimalwert und ein Maximalwert der Eingangsspannung während der jeweiligen Auswerteperiode ermittelt und am Ende der Auswertperiode von der Ablaufsteuerung z.B. abgefragt und ausgewertet werden.

Zweckmäßigerweise ist auf einer Eingangsseite des Analog-Digitalwandlers ein Spannungsteiler angeordnet, durch welche die Eingangsspannung auf einen für eine Signalverarbeitung geeigneten Spannungsbereich reduzierbar ist. Durch die entsprechende Dimensionierung kann z.B. die gleichgerichtete Eingangsspannung eines Schaltnetzteils, welche mittels einer ein- oder dreiphasigen Netzspannung versorgt wird, auf ein Spannungsniveau gebracht werden, welche für eine Signalverarbeitung durch z.B. elektronische Hardware (z.B. programmierbare Logik, Mikrocontroller) genutzt werden kann.

Eine spezielle Ausführungsvariante des erfindungsgemäßen Systems sieht vor, dass eine weitere Filtereinheit vorgesehen ist, welche zwischen einem Ausgang des Analog-Digitalwandlers und einem Eingang der Filtereinheit angeordnet ist. Diese Filtereinheit dient idealerweise einer Filterung der digitalisierten Eingangsspannung, um beispielsweise ein unerwünschtes Rauschen zu verringern und damit eine Auswertung der Eingangsspannung genauer zu machen. Diese Filtereinheit kann beispielsweise als Tiefpassfilter 1. Ordnung ausgeführt sein und kann z.B. ein Filterzeitkonstante aufweisen, welche gleich oder größer als die Abtastrate des Analog-Digitalwandlers ist.

Idealerweise wird das System mit Hilfe eines Mikrocontrollers oder einer programmierbaren Logik realisiert. Dabei kann beispielsweise ein bereits z.B. für eine Steuerung oder Regelung des Schaltnetzteils vorhandener Mikrocontroller für das System genutzt werden. Dabei kann z.B. der Analog-Digitalwandler in den Mikrocontroller integriert werden. Alternativ besteht allerdings auch die Möglichkeit, dass der Analog-Digitalwandler als eigenes Bauteil ausgeführt wird, welches die abgetastete Eingangsspannung in Form von einer Abfolge von Abtastwerten zur Verfügung stellt.

### Kurzbeschreibung der Zeichnung

Die Erfindung wird nachfolgend in beispielhafter Weise anhand der beigefügten Figuren erläutert. Es zeigen dabei:
Figur 1 schematisch und beispielhaft eine Realisierungsvariante des Systems zur Auswertung einer Eingangsspannung eines Schaltnetzteils
Figur 2a schematisch einen beispielhaften Ablauf des Verfahrens zur Auswertung einer Eingangsspannung eines Schaltnetzteils
Figur 2b schematisch einen beispielhaften Ablauf einer Auswertung von Vergleichsergebnissen der Komparatoreinheit
Figur 3 schematisch und beispielhaft eine weitere Realisierungsvariante des Systems zur Auswertung einer Eingangsspannung eines Schaltnetzteils

### Ausführung der Erfindung

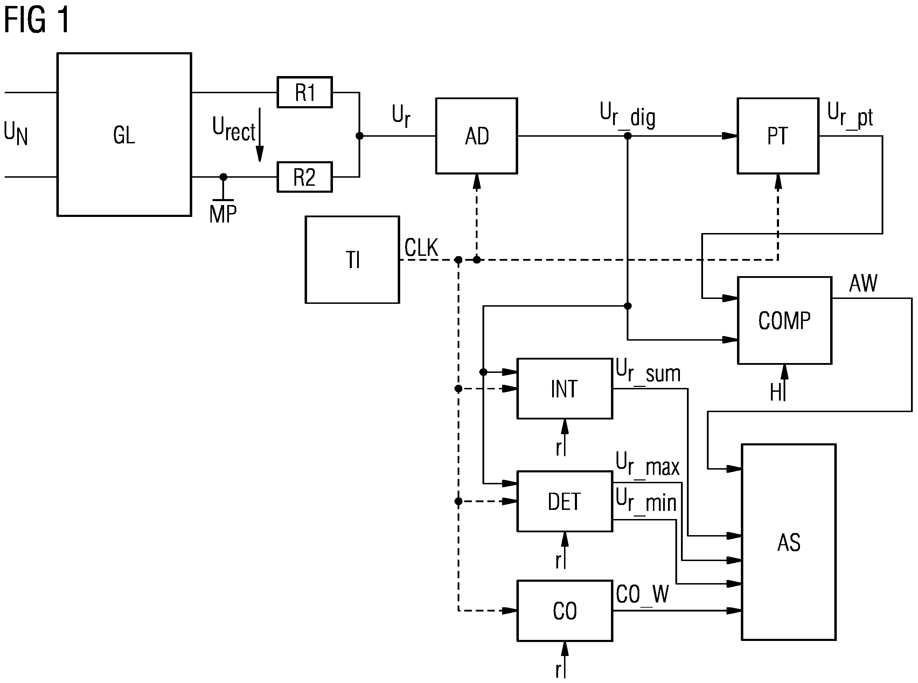

Figur 1 zeigt schematisch eine beispielhafte Realisierungsvariante des Systems zur Auswertung einer Eingangsspannung U_{rect} eines Schaltnetzteils, wobei das System Funktionseinheiten aufweist, welche als Hardware- und/oder Softwareeinheiten realisiert werden können, wobei als Softwareeinheiten ausgeführte Funktionseinheiten des Systems beispielsweise in einem Mikrocontroller realisiert sein können. Alternativ kann das System zumindest mit Hilfe einer programmierbaren Logik realisiert werden.

Das Schaltnetzteil wird dabei z.B. von einer Versorgungsspannung U_{N} versorgt. Die Versorgungsspannung U_{N} kann beispielsweise eine einphasige oder dreiphasige Netzspannung aus einem Energieversorgungsnetz sein. Die Versorgungspannung U_{N} wird einer Eingangsstufe GL des Schaltnetzteils zugeführt, wobei die Eingangsstufe GL z.B. in Abhängigkeit von der Versorgungsspannung U_{N} als 2-pulsige oder als 6-pulsige Gleichrichtereinheit GL ausgestaltet sein kann. Durch der Gleichrichtereinheit GL wird die Versorgungsspannung UN gleichgerichtet und eine Eingangsspannung U_{rect} für das Schaltnetzteil erzeugt. Die Eingangsspannung U_{rect}, welche auf ein Bezugspotential MP (z.B. 0 Volt) bezogen ist, weist eine definierte bzw. eindeutige Polarität auf. D.h. die Polarität ändert sich im zeitlichen Verlauf der Eingangsspannung U_{rect} nicht. Die Amplitude der Eingangsspannung U_{rect} weist allerdings zeitliche Veränderung - z.B. aufgrund eines sogenannten Rippels, welcher z.B. durch eine Gleichrichtung der Versorgungsspannung U_{N} durch die Gleichrichtereinheit GL entsteht - auf.

Die Eingangsspannung U_{rect} des Schaltnetzteils wird dann einem Spannungsteiler zugeführt, welche beispielsweise aus den Widerständen R1 und R2 besteht. Dieser Spannungsteiler bringt die Eingangsspannung U_{rect}, welche sich beispielsweise bei einer Versorgungs- bzw. Netzspannung U_{N} von z.B. 400 Volt in einem Bereich von ca. 550 Volt bewegt, in einen Spannungsbereich (z.B. ca. 3 bis 4 Volt), welcher für eine Durchführung des erfindungsgemäßen Verfahrens nutzbar bzw. signaltechnisch verarbeitbar ist. Durch den Spannungsteiler bzw. ein Verhältnis der Widerstände R1 und R2 wird die Eingangsspannung U_{rect} auf eine Eingangsspannung Uᵣ mit signalverarbeitbarer Höhe (z.B. 3,3 Volt) reduziert.

Die reduzierte Eingangsspannung Uᵣ wird auf einen Analog-Digitalwandler AD geführt, welcher eine Digitalisierung bzw. Abtastung der reduzierten Eingangsspannung Uᵣ durchführt. Der Analog-Digitalwandler AD kann beispielsweise als eigenes Bauteil ausgeführt sein oder in den Mikrocontroller integriert sein, von welchem das erfindungsgemäße Verfahren durchgeführt wird. Weiterhin kann es beispielsweise für eine korrekte Arbeitsweise des Analog-Digitalwandlers AD notwendig sein, einen Kondensator, welcher der Einfachheit halber nicht in Figur 1 eingezeichnet ist, an einen Eingang des Analog-Digitalwandler AD zu schalten. Der Kondensator sollte dabei so gewählt werden, dass eine Signalform der Eingangsspannung Uᵣ möglichst nicht beeinflusst wird. Vom Analog-Digitalwandler AD wird die analoge Eingangsspannung Uᵣ mit einer Abtastrate bzw. Abtastfrequenz abgetastet. Der Analog-Digitalwandler AD liefert dann eine abgetastete oder digitalisierte Eingangsspannung U_{r_dig} z.B. in Form einer zeitlichen Abfolge von Abtastwerten.

Die Abtastrate bzw. ein Takt für die Abtastung der reduzierten Eingangsspannung Uᵣ wird von einem Ausgangssignal bzw. einem Taktsignal CLK eines Taktgeber- oder Timereinheit TI geliefert. Von der Timereinheit TI wird damit durch sein Ausgangssignal bzw. durch das Taktsignal CLK eine zeitliche Steuerung des Analog-Digitalwandlers AD, aber auch der weiteren Funktionseinheiten des erfindungsgemäßen Systems übernommen. D.h. die jeweiligen Ausgangssignale dieser Funktionseinheiten stehen immer mit dem Takt CLK der Timereinheit TI am jeweiligen Ausgang der Funktionseinheit zur Verfügung. Eine Frequenz des Taktsignals CLK ist frei wählbar (z.B. 10kHz). Da das Taktsignal CLK allerdings auch die Abtastrate des Analog-Digitalwandlers AD bildet, ist zu beachten, dass die Abtastrate bzw. die Abtastfrequenz und damit des Taktsignal CLK wesentlich höher liegen als eine zu erwartende Frequenz der Wechselspannungsanteile bzw. des Rippels der auszuwertenden Eingangsspannung U_{rect} bzw. der reduzierten Eingangsspannung Uᵣ. Die Abtastfrequenz weist damit auch eine deutlich kürzere Periodendauer (z.B. 100ps) auf als der der Eingangsspannung U_{rect} des Schaltnetzteils bzw. der reduzierten Eingangsspannung Uᵣ überlagerter Rippel.

Die digitalisierte Eingangsspannung U_{r_dig} wird nun auf eine Filtereinheit PT geführt. Die Filtereinheit PT ist beispielsweise als digitale Tiefpassfiltereinheit 1. Ordnung ausgeführt, welches eine Verstärkung P (z.B. P = 1) und eine Zeitkonstante T aufweist. Dabei ist die Filterzeitkonstante T beispielsweise zumindest gleich oder größer der Periodendauer der Abtastrate CLK bzw. der Periodendauer des Taktsignals CLK. Die Filterzeitkonstante T kann beispielsweise die 4-fache oder idealerweise die 16-fache Periodendauer der Abtastrate bzw. des Taktsignals CLK betragen. Die Filtereinheit PT weist damit eine Filterwirkung sowie eine Laufzeit für ein gefilterte Ausgangssignal U_{r_pt} auf, wodurch z.B. das Ausgangssignal U_{r_pt} der Filtereinheit PT gegenüber dem Eingangssignal U_{r_dig} der Filtereinheit PT nacheilend bzw. zumindest zeitverzögert ist. D.h. das Ausgangssignal U_{r_pt} der Filtereinheit PT basiert auf einem Abtastwert der digitalisierten Eingangsspannung U_{r_dig}, welcher zeitlich gesehen vor einem Abtastwert der digitalisierten Eingangsspannung U_{r_dig} liegt, welcher als Eingangssignal U_{r_dig} der Filtereinheit PT beim selben Taktsignal CLK der Timereinheit TI bzw. bei derselben Taktflanke des Taktsignals CLK am Eingang der Filtereinheit PT ansteht.

Das Eingangssignal U_{r_dig} der Filtereinheit PT und das Ausgangssignal U_{r_pt} der Filtereinheit PT werden dann einer Komparatoreinheit COMP zugeführt. Je nachdem ob das Eingangssignal U_{r_dig} der Filtereinheit PT größer oder kleiner als das Ausgangssignal U_{r_pt} der Filtereinheit PT ist, kann ein Vergleichsergebnis AW am Ausgang der Komparatoreinheit COMP einen unterschiedlichen Wert bzw. Zustand annehmen. Dabei kann z.B. das Vergleichsergebnis AW einen ersten Wert bzw. Zustand annehmen, wenn das Eingangssignal U_{r_dig} der Filtereinheit PT kleiner als das Ausgangssignal U_{r_pt} der Filtereinheit PT ist. Ist das Eingangssignal U_{r_dig} der Filtereinheit PT größer als das Ausgangssignal U_{r_pt} der Filtereinheit PT, so wird z.B. vom Vergleichsergebnis AW am Ausgang der Komparatoreinheit COMP ein zweiter Wert bzw. Zustand angenommen.

Der Vergleich, welches der beiden Signale U_{r_dig}, U_{r_pt} der Filtereinheit PT größer bzw. kleiner ist, kann von der Komparatoreinheit COMP beispielsweise ohne Hysterese H oder mit Hysterese H durchgeführt werden. Bei Verwendung einer Hysterese H beim kann beispielsweise ein etwaiges Signalrauschen Fehlmessungen reduzieren oder verhindern. Die Hysterese H kann dabei beispielsweise, je nachdem welches Vergleichsergebnis AW vorliegt bzw. welchen Wert bzw. Zustand das Vergleichsergebnis AW am Ausgang der Komparatoreinheit COMP angenommen hat, zum Eingangssignal U_{r_dig} und zum Ausgangssignal U_{r_pt} der Filtereinheit PT dazugezählt oder von diesen abgezogen werden. Dadurch wird eine Mitkopplung bzw. positive Rückkopplung erreicht, welche das Vergleichsergebnis AW der Komparatoreinheit COMP stabiler macht.

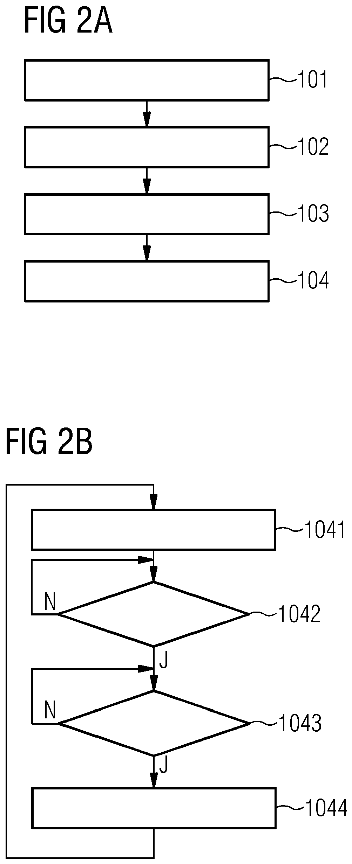

Das Vergleichsergebnis AW der Komparatoreinheit COMP wird als jeweils aktueller Wert bzw. Zustand am Ausgang der Komparatoreinheit COMP an eine Ablaufsteuerung AS weitergeleitet. Die Ablaufsteuerung steuert einen Ablauf der Auswertung der Eingangsspannung U_{rect} bzw. der reduzierten Eingangsspannung Uᵣ und kann damit eine Dauer einer jeweiligen Auswerteperiode sowie daraus eine Frequenz eines der Eingangsspannung U_{rect} bzw. Uᵣ überlagerten Wechselspannungsanteil bzw. Rippel ermitteln. Dazu ist die Ablaufsteuerung beispielweise als Zustandsmaschine bzw. so genannte State Machine ausgestaltet, welche von einem aktuellen, ersten Zustand in einen neuen, zweiten Zustand übergehen kann, wenn es zu einer ersten Änderung des Vergleichsergebnisses AW am Ausgang der Komparatoreinheit COMP kommt bzw. sich der Wert bzw. Zustand am Ausgang der Komparatoreinheit COMP zum ersten Mal ändert. Bein einer weiteren Änderung des Vergleichsergebnisses AW am Ausgang der Komparatoreinheit COMP kann die Ablaufsteuerung AS vom zweiten Zustand über einen dritten Zustand oder Berechnungszustand und einen Rücksetzschritt wieder in den ersten Zustand wechseln. Ein detaillierter Ablauf der Auswertung der Vergleichsergebnisse AW der Komparatoreinheit COMP durch die Ablaufsteuerung AS ist beispielhaft in Figur 2b dargestellt und wird anhand dieser noch genauer beispielhaft beschrieben.

Die Ablaufsteuerung AS erhält weiterhin Signale von einer Zählereinheit CO, einer Integratoreinheit INT und einer Detektoreinheit DET zur Verfügung gestellt und kann diese durch ein Resetsignal r beispielsweise zum Starten einer jeweiligen Auswerteperiode zurücksetzen.

Dabei werden von der Zählereinheit CO die Impulse des Taktsignals CLK der Timereinheit TI gezählt. Die Zählereinheit CO kann zu Beginn der jeweiligen Auswerteperiode mittels des Resetsignals r durch die Ablaufsteuerung AS gestartet werden. Am Ende der jeweiligen Auswerteperiode liefert die Zählereinheit CO einen Zählerwert CO_W bzw. einen Zählerstand CO_W an die Ablaufsteuerung AS, aus welchem eine Dauer der jeweiligen Auswerteperiode ableitbar ist. Danach kann die Zählereinheit CO wieder mittels des Resetsignals r der Ablaufsteuerung AS für eine neue Auswerteperiode zurückgesetzt.

Von der Integratoreinheit INT wird über die jeweiligen Auswerteperiode die Signale bzw. Abtastwerte der digitalisierte Eingangsspannung U_{r_dig} aufsummiert. Am Ende der jeweiligen Auswerteperiode kann die Integratoreinheit INT der Ablaufsteuerung AS einen Summenwert U_{r_sum} der digitalen Eingangsspannung U_{r_dig} zur Verfügung stellen, aus welchem von der Ablaufsteuerung AS z.B. eine Mittelwert der Eingangsspannung U_{rect} abgeleitet werden kann. Die Integratoreinheit INT kann ebenfalls mit dem Resetsignal r zum Start jeder neuerlichen Auswerteperiode zurückgesetzt werden. Auch die Integratoreinheit INT wird mittels des Taktsignals CLK der Timereinheit TI getaktet.

Von der Detektoreinheit DET werden während der jeweiligen Auswerteperiode ein maximaler Wert U_{r_max} der digitalisierten Eingangsspannung U_{r_dig} und ein minimaler Wert U_{r_min} der digitalisierten Eingangsspannung U_{r_dig} detektiert. Am Ende der jeweiligen Auswerteperiode werden diese Werte U_{r_max}, U_{r_min} der Ablaufsteuerung AS zur Verfügung gestellt. Die Detektoreinheit DET kann ebenfalls mit dem Resetsignal r zum Start jeder neuerlichen Auswerteperiode zurückgesetzt werden. Weiterhin wird auch die Detektoreinheit DET mit dem Taktsignal CLK der Timereinheit TI getaktet.

Figur 2a zeigt schematisch und beispielhaft einen Ablauf des Verfahrens zum Auswerten der Eingangsspannung U_{rect} eines Schaltnetzteils. Dabei weiset die Eingangsspannung U_{rect} eine eindeutige bzw. definierte Polarität, aber einen sich zeitlich ändernde Amplitude auf. Vor einem ersten Schritt 101 des Verfahrens kann die Eingangsspannung U_{rect} mittels eines Spannungsteilers R1, R2 in einen Spannungsbereich gebracht werden, welcher für eine Signalverarbeitung durch z.B. einen Mikrokontroller geeignet ist. Die Eingangsspannung U_{rect} des Schaltnetzteils wird z.B. auf eine Eingangsspannung Uᵣ reduziert.

Im ersten Schritt 101 bzw. in einem Digitalisierungsschritt 101 wird die reduzierte Eingangsspannung Uᵣ vom Analog-Digitalwandler AD in die digitalisierte Eingangsspannung U_{r_dig} umgewandelt. Dazu wird die Eingangsspannung Uᵣ mit einer Abtastrate bzw. Abtastfrequenz, welche beispielsweise vom Taktsignal CLK der Timereinheit TI vorgegeben wird, abgetastet. Am Ausgang des Analog-Digitalwandlers AD steht dann die abgetastete oder digitalisierte Eingangsspannung U_{r_dig} z.B. in Form einer zeitlichen Abfolge von Abtastwerten zur Verfügung.

Die digitalisierte Eingangsspannung U_{r_dig} wird dann in einem Filterungsschritt 102 für eine Filterung der Filtereinheit PT zugeführt. Die Filtereinheit PT ist dabei derart ausgestaltet, dass das Ausgangssignal U_{r_pt} der Filtereinheit PT gegenüber dem Eingangssignal, welche von der der digitalisierten Eingangsspannung U_{r_dig} gebildet wird, zumindest zeitverzögert ist. D.h., das Ausgangssignal U_{r_pt} der Filtereinheit PT ist gegenüber dem Eingangssignal U_{r_dig} der Filtereinheit PT nacheilend und basiert auf einem Abtastwert der digitalisierten Eingangsspannung U_{r_dig}, welcher zeitlich gesehen vor einem Abtastwert der digitalisierten Eingangsspannung U_{r_dig} liegt, welcher als Eingangssignal am Eingang der Filtereinheit PT beim selben Taktsignal CLK der Timereinheit TI ansteht.

Das Eingangssignal U_{r_dig} und das Ausgangssignal U_{r_pt} der Filtereinheit PT werden in einem Vergleichsschritt 103 der Komparatoreinheit COMP zugeführt und miteinander verglichen. Das Vergleichsergebnis AW am Ausgang der Komparatoreinheit COMP kann z.B. unterschiedliche Wert bzw. Zustände annehmen, je nachdem ob das Eingangssignal U_{r_dig} oder das Ausgangssignal U_{r_pt} der Filtereinheit PT größer ist. Das im Vergleichsschritt 103 ermittelte Vergleichsergebnis AW wird dann an die Ablaufsteuerung AS weitergeleitet.

Von der Ablaufsteuerung AS wird dann in einem Auswertungsschritt 104 das von der Komparatoreinheit COMP gelieferte Vergleichsergebnis AW ausgewertet. Die Ablaufsteuerung AS ist für eine Auswertung der Vergleichsergebnisse AW, welche von der Komparatoreinheit COMP laufend geliefert werden, beispielsweise als Zustandsmaschine oder so genannte State Machine ausgestaltet.

Ein Ablauf der Auswertung von Vergleichsergebnissen, welche von der Komparatoreinheit COMP geliefert werden, durch die Ablaufsteuerung AS ist schematisch und beispielhaft in Figur 2b dargestellt.

Zum Starten einer Auswerteperiode wird von der Ablaufsteuerung AS in einem Rücksetzschritt 1041 die Zählereinheit CO durch das Resetsignal r auf einen Ausgangswert (z.B. den Wert 0) zurückgesetzt. Von der Zählereinheit CO werden die Impulse des Taktsignals CLK der Timereinheit TI während der jeweiligen Auswerteperiode gezählt. Zusätzlich können auch die Integratoreinheit INT und die Detektoreinheit DET auf jeweilige Ausgangswerte (z.B. Wert 0) zurückgesetzt werden und damit eine Aufsummierung der digitalisierten Eingangsspannung U_{r_dig} über die jeweilige Auswerteperiode und ein Erkennen von Minimal- und Maximalwert U_{r_min}, U_{r_max} der digitalisierten Eingangsspannung U_{r_dig} während der jeweiligen Auswerteperiode gestartet werden. Von der Ablaufsteuerung AS wird dann z.B. nach dem Rücksetzschritt 1041 z.B. in den ersten Zustand gewechselt.

In einem ersten Prüfschritt 1042 werden von der Ablaufsteuerung die laufend von der Komparatoreinheit COMP gelieferten Vergleichsergebnisse AW auf eine erste Zustandsänderung überprüft. D.h., von der Ablaufsteuerung AS wird ausgewertet, ob sich der Wert bzw. der Zustand am Ausgang der Komparatoreinheit COMP verändert. Solange von der Komparatoreinheit COMP ein unverändertes Vergleichsergebnis AW geliefert wird (z.B. das Eingangssignal U_{r_dig} der Filtereinheit PT bleibt kleiner als das Ausgangssignal U_{r_pt} bzw. das Eingangssignal U_{r_dig} der Filtereinheit PT bleibt größer als das Ausgangssignal U_{r_pt}) und damit ein aktueller Wert bzw. Zustand am Ausgang der Komparatoreinheit COMP beibehalten wird, bleibt auch die Ablaufsteuerung AS im ersten Zustand und es wird weiterhin den ersten Prüfschritt 1042 aufgeführt.

Wird im ersten Prüfschritt 1042 allerdings eine erste Änderung des Werts bzw. Zustands am Ausgang der Komparatoreinheit COMP festgestellt, so wechselt die Ablaufsteuerung AS vom ersten Zustand in den zweiten Zustand und es wird vom ersten Prüfschritt 1042 auf einen zweiten Prüfschritt 1043 gewechselt. D.h., ändert sich das Vergleichsergebnis AW am Ausgang der Komparatoreinheit COMP, weil z.B. das Eingangssignal U_{r_dig} der Filtereinheit PT größer als das Ausgangssignal U_{r_pt} wird bzw. weil das Eingangssignal U_{r_dig} der Filtereinheit PT kleiner als das Ausgangssignal U_{r_pt} wird, so wird auch der aktuelle Zustand der Ablaufsteuerung AS vom ersten auf den zweiten Zustand geändert.

Im zweiten Prüfschritt 1043 werden dann wieder die laufend von der Komparatoreinheit COMP gelieferten Vergleichsergebnisse AW auf eine weitere Änderung überprüft. Solange von der Ablaufsteuerung AS keine Zustandsveränderung des Werts bzw.

Zustands am Ausgang der Komparatoreinheit COMP anhand der gelieferten Vergleichsergebnisse AW festgestellt wird, bleibt die Ablaufsteuerung AS im zweiten Zustand und es wird weiterhin der zweite Prüfschritt 1043 ausgeführt. D.h., solange z.B. das Eingangssignal U_{r_dig} der Filtereinheit PT größer als das Ausgangssignal U_{r_pt} der Filtereinheit PT bleibt bzw. das Eingangssignal U_{r_dig} der Filtereinheit PT kleiner als das Ausgangssignal U_{r_pt} bleibt, wird von der Ausgangssteuerung AS der zweite Zustand beibehalten und auf die weitere Änderung des Vergleichergebnisses AW gewartet.

Wird im zweiten Prüfschritt 1043 eine weitere bzw. zweite Änderung des Vergleichergebnisses AW der Komparatoreinheit COMP festgestellt, weil z.B. das Eingangssignal U_{r_dig} der Filtereinheit PT wieder kleiner als das Ausgangssignal U_{r_pt} der Filtereinheit PT geworden ist bzw. weil das Eingangssignal U_{r_dig} der Filtereinheit PT wieder größer als das Ausgangssignal U_{r_pt} geworden ist, so wechselt die Ablaufsteuerung in den dritten Zustand bzw. in den Berechnungszustand, in welchem dann ein Berechnungsschritt 1044 ausgeführt wird.

Im Berechnungsschritt 1044 wird dann die jeweilige Auswerteperiode beendet und von der Ablaufsteuerung AS z.B. ein aktueller Zählerwert CO_W der Zählereinheit CO abgefragt. Weiterhin können auch der aktuelle Summenwert U_{r_sum} aus der Integratoreinheit INT sowie ein von Detektoreinheit DET während der jeweiligen Auswerteperiode festgestellter Minimalwert U_{r_min} und Maximalwert U_{r_max} der digitalisierten Eingangsspannung U_{r_dig} an die Ablaufsteuerung AS übermittelt werden.

Weiterhin können im Berechnungsschritt 1044 aus dem für die jeweilige Auswerteperiode abgefragten Zählerwert CO_W, der Frequenz des Taktsignals CLK und dem für die jeweilige Auswerteperiode übermittelten Summenwert U_{r_sum} der digitalisierten Eingangsspannung U_{r_dig} eine Frequenz des Wechselspannungsanteils sowie ein Mittelwert der Eingangsspannung U_{rect} abgeleitet werden. Zum Ermitteln der Frequenz des Wechselspannungsanteils der Eingangsspannung U_{rect} wird z.B. die Frequenz des Taktsignals CLK durch den für die jeweilige Auswerteperiode ermittelten Zählerwert CO_W dividiert. Zum Bestimmen des Mittelwerts der Eingangsspannung U_{rect} kann beispielsweise der über die jeweilige Auswerteperiode bestimmte Summenwert U_{r_sum} der digitalisierten Eingangsspannung U_{r_dig} durch den für die jeweilige Auswerteperiode ermittelten Zählerwert CO_W dividiert werden.

Nach dem Berechnungsschritt 1044 wird wieder der Rücksetzschritt 1041 ausgeführt. Dabei können die Zählereinheit CO, die Integratoreinheit INT sowie die Detektoreinheit DET wieder mittels des Resetsignals r von der Ablaufsteuerung AS für einen nächste Auswerteperiode auf die jeweiligen Ausgangswerte zurückgesetzt werden. Mit dem Rücksetzschritt 1041 wird die nächste Auswerteperiode gestartet und von der Ablaufsteuerung wieder der erste Zustand angenommen, um wieder z.B. weitere Vergleichsergebnisse AW der Komparatoreinheit COMP mittels des ersten und zweiten Prüfschritts 1042, 1043 auszuwerten.

Wird beispielsweise während des ersten Prüfschritts 1042 und/oder während des zweiten Prüfschritts 1043 kein Änderung des Vergleichsergebnisses AW der Komparatoreinheit COMP festgestellt, so kann das Verfahren beendet werden, wenn der Wert der Zählereinheit CO einen vorgegebenen Zählerwert erreicht oder überschreitet. D.h., die laufende Auswerteperiode wird mittels bei Erreichen oder Überschreiten des vorgegebenen Zählerwerts beendet bzw. abgebrochen. Dabei können z.B. wieder die Ablaufsteuerung AS in den ersten Zustand versetzt sowie die Zählereinheit CO, die Integratoreinheit INT und die Detektoreinheit DET auf die jeweiligen vorgegebenen Ausgangswerte zurückgesetzt werden.

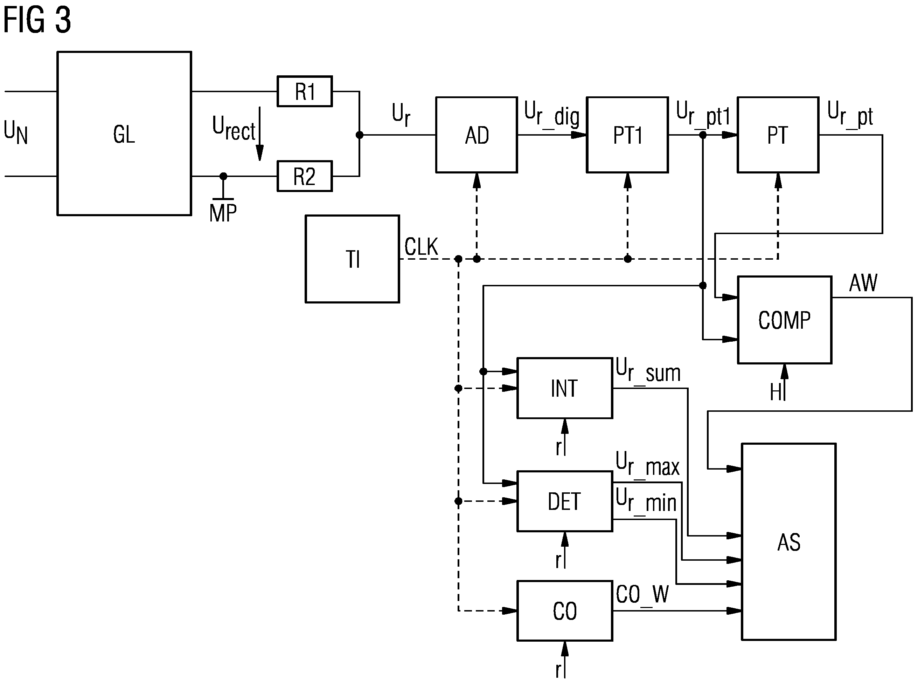

Figur 3 zeigt eine weitere Realisierungsvariante des Systems zur Auswertung einer Eingangsspannung U_{rect} eines Schaltnetzteils, mit welcher das erfindungsgemäße Verfahren durchführbar ist. Dabei wird die Eingangsspannung U_{rect} des Schaltnetzteils wieder mittels des Spannungsteilers R1, R2 auf eine Eingangsspannung Uᵣ mit signalverarbeitbarer Höhe (z.B. 3,3 Volt) reduziert. Die reduzierte Eingangsspannung Uᵣ wird wieder dem Analog-Digitalwandler AD zugeführt, von welchem die reduzierte Eingangsspannung Uᵣ unter Verwendung des Abtastsignals bzw. des Taktsignals CLK der Timereinheit TI digitalisiert wird. Die digitalisierte Eingangsspannung U_{r_dig} wird dann - im Gegensatz zur in Figur 1 dargestellten Realisierungsvariante - zuerst an eine weitere Filtereinheit PT1 geführt, welche eingangsseitig mit dem Analog-Digitalwandler AD verbunden ist. Ausgangsseitig ist an die weitere Filtereinheit PT1 die Filtereinheit PT angebunden, wobei nun das Ausgangssignal U_{r_pt1} der weiteren Filtereinheit PT1 das Eingangssignal der Filtereinheit PT bildet. Die weitere Filtereinheit PT1 dient vor allem einer Unterdrückung bzw. einer Reduktion eines Rauschens in der digitalisierten Eingangsspannung U_{r_dig}. Die weitere Filtereinheit PT1 kann beispielsweise ebenfalls als Tiefpassfilter 1. Ordnung ausgeführt sein und eine Verstärkung P (z.B. P = 1) aufweisen. Weiterhin weist die weitere Filtereinheit PT1 eine Filterzeitkonstante T, welche beispielsweise gleich oder größer der Periodendauer der Abtastrate CLK bzw. der Periodendauer des Taktsignals CLK ist.

Der Komparatoreinheit COMP werden dann zum Vergleichen das Ausgangssignal U_{r_pt1} der weiteren Filtereinheit PT1, welches nun das Eingangssignal der Filtereinheit PT bildet, sowie das Ausgangssignal U_{r_pt} der Filtereinheit PT zugeführt. Die beiden Signale U_{r_pt1}, U_{r_pt} können dann wieder mit oder ohne Hysterese H miteinander verglichen werden.

Die Komparatoreinheit COMP liefert dann wieder Vergleichsergebnisse AW an die Ablaufsteuerung AS, welche dann wieder die Auswertung der Vergleichsergebnisse - wie anhand von Figur 2b beschrieben - steuert. Auch die in Figur 3 dargestellte Realisierungsvariante weist die Zählereinheit CO, die Integratoreinheit INT sowie die Detektoreinheit DET auf, welche ebenfalls mittels des Taktsignals CLK der Timereinheit TI getaktet werden und durch das Resetsignal r von der Ablaufsteuerung AS zurückgesetzt werden können. Allerdings wird der Integratoreinheit INT und der Detektoreinheit DET bei der in Figur 3 dargestellten Realisierungsvariante als Eingangssignal von der weiteren Filtereinheit PT1 gefilterte, digitalisierte Eingangsspannung U_{r_pt1} zugeführt, um verbesserte Ausgangswerte U_{r_sum}, U_{r_min}, U_{r_max} am Ende der jeweiligen Auswerteperiode zu erhalten.

## Patentansprüche

1. Verfahren zum Auswerten einer Eingangsspannung (U_{rect}) eines Schaltnetzteils, wobei die Eingangsspannung (U_{rect}) eine vorgegebene Polarität aufweist, ***dadurch gekennzeichnet, dass*** die Eingangsspannung (Uᵣ, U_{rect}) mittels Abtastung mit einer vorgegebenen Abtastrate digitalisiert wird (101), dass die digitalisierte Eingangsspannung (U_{r_dig}) als Eingangssignal einer Filtereinheit (PT) derart gefiltert wird (102), dass ein Ausgangssignal (U_{r_pt}) der Filtereinheit (PT) dem Eingangssignal (U_{r_dig}) der Filtereinheit (PT) nacheilt, dass das Eingangssignal (U_{r_dig}) der Filtereinheit (PT) mit dem Ausgangssignal (U_{r_pt}) der Filtereinheit (PT) mittels einer Komparatoreinheit (COMP) verglichen werden (103), und dass von der Komparatoreinheit gelieferte Vergleichsergebnisse (AW) ausgewertet werden (104), wobei während einer jeweiligen Auswerteperiode, welche durch Rücksetzen einer Zählereinheit (CO) gestartet wird (1041), von der Komparatoreinheit (COMP) gelieferte Vergleichsergebnisse solange ausgewertet werden, bis nach einer ersten Zustandsänderung eines Vergleichsergebnisses (AW) eine weitere Zustandsänderung eines Vergleichsergebnisses (AW) festgestellt wird (1042, 1043), und wobei dann die jeweilige Auswerteperiode beendet und anhand eines aktuellen Zählerwerts (CO_W) der Zählereinheit (CO) eine Periodendauer und/oder eine Frequenz eines Wechselspannungsanteils der Eingangsspannung (Uᵣ, U_{rect}) ermittelt wird (1044).

2. Verfahren nach Anspruch 1, ***dadurch gekennzeichnet, dass*** für eine Ermittlung eines Mittelwerts der Eingangsspannung (Uᵣ, U_{rect}) ein Summenwert (U_{r_sum}) der über die jeweilige Auswerteperiode aufsummierten, digitalisierten Eingangsspannung (U_{r_dig}) sowie der aktuelle Zählerwert (CO_W) an einem Ende der jeweiligen Auswerteperiode herangezogen werden (1044).

3. Verfahren nach einem Ansprüche 1 bis 2, ***dadurch gekennzeichnet, dass*** während einer jeweiligen Auswerteperiode ein Minimalwert (U_{r_min}) und ein Maximalwert (U_{r_max}) der digitalisierten Eingangsspannung (U_{r_dig}) detektiert werden (1044) .

4. Verfahren nach einem der vorangegangenen Ansprüche, ***dadurch gekennzeichnet, dass*** die Eingangsspannung (U_{rect}) vor der Abtastung auf einen für eine Signalverarbeitung geeigneten Spannungsbereich reduziert wird.

5. Verfahren nach einem der vorangegangenen Ansprüche, ***dadurch gekennzeichnet, dass*** von der Komparatoreinheit (COMP) beim Vergleichen des Eingangssignals (U_{r_dig}) der Filtereinheit (PT) mit dem Ausgangssignal (U_{r_pt}) der Filtereinheit (PT) eine Hysterese (H) verwendet wird (103).

6. Verfahren nach einem der vorangegangenen Ansprüche, ***dadurch gekennzeichnet, dass*** bei Erreichen eines vorgegebenen maximalen Zählerwerts (CO_W) der Zählereinheit (CO) ein Auswerten des Vergleichsergebnisses (AW) der Komparatoreinheit (COMP) beendet wird (1042, 1043).

7. Verfahren nach einem der vorangegangenen Ansprüche, ***dadurch gekennzeichnet, dass*** nach einer Digitalisierung der Eingangsspannung (Uᵣ, U_{rect}) eine Rauschreduktion und/oder Rauschunterdrückung durchgeführt wird.

8. System zum Auswerten einer Eingangsspannung (U_{rect}) eines Schaltnetzteils, wobei die Eingangsspannung (U_{rect}) eine vorgegebene Polarität aufweist, ***dadurch gekennzeichnet,** d**ass*** das System für eine Durchführung eines Verfahrens nach den Ansprüchen 1 bis 7 zumindest folgende Funktionseinheiten aufweist:
- einen Analog-Digitalwandler (AD) zum Digitalisieren der Eingangsspannung (Uᵣ, U_{rect}), wobei die Eingangsspannung (Uᵣ, U_{rect}) mit einer vorgegebenen Abtastrate (CLK) abgetastet wird;
- zumindest eine Filtereinheit (PT) zum Filtern der digitalisierten Eingangsspannung (U_{r_dig}) als Eingangssignal, wobei die Filtereinheit (PT) derart ausgestaltet ist, dass ein Ausgangssignal (U_{r_pt}) der Filtereinheit (PT) dem Eingangssignal (U_{r_dig}) der Filtereinheit (PT) nacheilend ist;
- eine Komparatoreinheit (COMP) zum Vergleichen des Eingangssignals (U_{r_dig}) der Filtereinheit (PT) mit dem Ausgangssignal (U_{r_pt}) der Filtereinheit (PT);
- eine Zählereinheit (CO) zum Messen einer jeweiligen Auswerteperiode, welche zu Beginn der jeweiligen Auswerteperiode rücksetzbar ist;
- eine Ablaufsteuerung (AS), welche dazu eingerichtet ist:
o eine jeweilige Auswerteperiode durch Rücksetzen zumindest der Zählereinheit (CO) zu starten;
o von der Komparatoreinheit (COMP) gelieferte Vergleichsergebnisse (AW) solange auszuwerten, bis nach einer ersten Zustandsänderung eines Vergleichsergebnisses (AW) eine weitere Zustandsänderung eines Vergleichsergebnisses (AW) festgestellt wird;
o eine jeweilige Auswerteperiode nach dem weiteren Ausgangszustandswechsel der Komparatoreinheit (COMP) zu beenden und zumindest einen aktuellen Zählerwert (CO_W) der Zählereinheit (CO) abzufragen, um eine Periodendauer und/oder eine Frequenz eines Wechselspannungsanteils der Eingangsspannung zu ermitteln; und
- eine Timereinheit (TI), welche durch ein Taktsignal (CLK) eine zeitliche Steuerung sowie die Abtastrate (CLK) des Analog-Digitalwandlers (AD) vorgibt.

9. System nach Anspruch 8, ***dadurch gekennzeichnet, dass*** weiterhin eine Integratoreinheit (INT) zum Aufsummieren der digitalisierten Eingangsspannung (U_{r_dig}) über die jeweilige Auswerteperiode vorgesehen ist, wobei die Integratoreinheit (INT) am Beginn der jeweiligen Auswerteperiode rücksetzbar ist.

10. System nach einem der Ansprüche 8 bis 9, ***dadurch gekennzeichnet, dass*** weiterhin eine Detektoreinheit (DET) zum Detektieren von Spitzenwerten (U_{r_min}, U_{r_max}) der digitalisierten Eingangsspannung (U_{r_dig}) während der jeweiligen Auswerteperiode vorgesehen ist, wobei die Detektoreinheit (DET) am Beginn der jeweiligen Auswerteperiode rücksetzbar ist.

11. System nach einem der Ansprüche 8 bis 10, ***dadurch gekennzeichnet, dass*** auf einer Eingangsseite des Analog-Digitalwandlers (AD) ein Spannungsteiler (R1, R2) angeordnet ist, durch welche die Eingangsspannung (U_{rect}) auf einen für eine Signalverarbeitung geeigneten Spannungsbereich reduzierbar ist.

12. System nach einem der Ansprüche 8 bis 11, ***dadurch gekennzeichnet, dass*** weiterhin eine weitere Filtereinheit (PT1) vorgesehen ist, welche zwischen einem Ausgang des Analog-Digitalwandlers (AD) und einem Eingang der Filtereinheit (PT) angeordnet ist.

13. System nach einem der Ansprüche 8 bis 12, ***dadurch gekennzeichnet, dass*** das System mit Hilfe eines Mikrocontrollers oder einer programmierbaren Logik realisierbar ist.

## Claims

1. Method for evaluating an input voltage (U_{rect}) of a switched-mode power supply, wherein the input voltage (U_{rect}) has a predetermined polarity, ***characterised in that*** the input voltage (Uᵣ, U_{rect}) is digitised by being sampled at a predetermined sampling rate (101), **in that** the digitised input voltage (U_{r_dig}), as the input signal to a filter unit (PT), is filtered (102) such that an output signal (U_{r_pt}) from the filter unit (PT) lags the input signal (U_{r_dig}) of the filter unit (PT), **in that** the input signal (U_{r_dig}) of the filter unit (PT) is compared with the output signal (U_{r_pt}) from the filter unit (PT) using a comparator unit (COMP) (103), and **in that** comparison results (AW) delivered by the comparator unit are evaluated (104), wherein, during a respective evaluation period that is started by resetting a counter unit (CO) (1041), comparison results that have been delivered by the comparator unit (COMP) are evaluated until, following a first change in state of a comparison result (AW), a further change in state of a comparison result (AW) is identified (1042, 1043), and wherein the respective evaluation period is then terminated and, using a present count value (CO_W) of the counter unit (CO), a period duration and/or a frequency of an AC voltage component of the input voltage (Uᵣ, U_{rect}) are determined (1044).

2. Method according to claim 1, *c**haracterised in that,*** for the purpose of determining an average value of the input voltage (Uᵣ, U_{rect}), a sum value (U_{r_sum}) of the digitised input voltage (U_{r_dig}) added up over the respective evaluation period and the present count value (CO_W) at an end of the respective evaluation period are used (1044).

3. Method according to one of claims 1 to 2, ***characterised in that**,* during a respective evaluation period, a minimum value (U_{r_min}) and a maximum value (U_{r_max}) of the digitised input voltage (U_{r_dig}) are detected (1044).

4. Method according to one of the preceding claims,
***characterised in that*** before sampling the input voltage (U_{rect}) is reduced to a voltage range suitable for signal processing.

5. Method according to one of the preceding claims,
***characterised in that*** the comparator unit (COMP) makes use of a hysteresis (H) when comparing the input signal (U_{r_dig}) of the filter unit (PT) with the output signal (U_{r_pt}) from the filter unit (PT) (103).

6. Method according to one of the preceding claims,
***characterised in that,*** when a predetermined maximum count value (CO_W) of the counter unit (CO) is reached, evaluation of the comparison result (AW) from the comparator unit (COMP) is terminated (1042, 1043).

7. Method according to one of the preceding claims,
***characterised in that,*** after digitisation of the input voltage (Uᵣ, U_{rect}) , a noise reduction and/or noise suppression is carried out.

8. System for evaluating an input voltage (U_{rect}) of a switched-mode power supply, wherein the input voltage (U_{rect}) has a predetermined polarity, ***characterised in that*** the system for carrying out a method according to claims 1 to 7 has at least the following functional units:
- an analogue-to-digital converter (AD) for digitising the input voltage (Uᵣ, U_{rect}), wherein the input voltage (Uᵣ, U_{rect}) is sampled at a predetermined sampling rate (CLK);
- at least one filter unit (PT) for filtering the digitised input voltage (U_{r_dig}) as the input signal, wherein the filter unit (PT) takes a form such that an output signal (U_{r_pt}) from the filter unit (PT) lags the input signal (U_{r_dig}) of the filter unit (PT);
- a comparator unit (COMP) for comparing the input signal (U_{r_dig}) of the filter unit (PT) with the output signal (U_{r_pt}) from the filter unit (PT);
- a counter unit (CO) for measuring a respective evaluation period, wherein the counter unit can be reset at the start of the respective evaluation period;
- a sequence control system (AS) that is configured to:
o start a respective evaluation period by resetting at least the counter unit (CO);
o evaluate comparison results (AW) delivered by the comparator unit (COMP) until, following a first change in state of a comparison result (AW), a further change in state of a comparison result (AW) is identified;
o after the further change in the starting state of the comparator unit (COMP), terminate a respective evaluation period, and retrieve at least a present count value (CO_W) of the counter unit (CO) in order to determine the duration of a period and/or a frequency of an AC voltage component of the input voltage; and
- a timer unit (TI) that uses a clock signal (CLK) to set a time control and the sampling rate (CLK) of the analogue-to-digital converter (AD).

9. System according to claim 8, ***characterised in that*** furthermore an integrator unit (INT) is provided for adding up the digitised input voltage (U_{r_dig}) over the respective evaluation period, wherein the integrator unit (INT) can be reset at the start of the respective evaluation period.

10. System according to one of claims 8 to 9, ***characterised in that*** furthermore a detector unit (DET) is provided, for detecting peak values (U_{r_min}, U_{r_max}) of the digitised input voltage (U_{r_dig}) during the respective evaluation period, wherein the detector unit (DET) can be reset at the start of the respective evaluation period.

11. System according to one of claims 8 to 10, ***characterised in that*** there is arranged on an input side of the analogue-to-digital converter (AD) a voltage divider (R1, R2), which can reduce the input voltage (U_{rect}) to a voltage range suitable for signal processing.

12. System according to one of claims 8 to 11, ***characterised in that*** furthermore a further filter unit (PT1) is provided, arranged between an output of the analogue-to-digital converter (AD) and an input of the filter unit (PT).

13. System according to one of claims 8 to 12, ***characterised in that*** the system can be implemented with the aid of a microcontroller or a programmable logic circuit.

## Revendications

1. Procédé destiné à l'évaluation d'une tension d'entrée (U_{rect}) d'une alimentation à découpage, dans lequel la tension d'entrée (U_{rect}) présente une polarité prédéfinie, ***caractérisé en ce que*** la tension d'entrée (Uᵣ, U_{rect}) est numérisée (101) au moyen d'un balayage avec une fréquence de balayage prédéfinie, **en ce que** la tension d'entrée numérisée (U_{r_dig}) est filtrée (102) en tant que signal d'entrée d'une unité filtrante (PT) de telle sorte qu'un signal de sortie (U_{r_pt}) de l'unité filtrante (PT) poursuit le signal d'entrée (U_{r_dig}) de l'unité filtrante (PT), **en ce que** le signal d'entrée (U_{r_dig}) de l'unité filtrante (PT) est comparé (103) avec le signal de sortie (U_{r_pt}) de l'unité filtrante (PT) au moyen d'une unité de comparaison (COMP), et **en ce que** des résultats de comparaison (AW) livrés par l'unité de comparaison sont évalués (104), dans lequel pendant une période d'évaluation respective, qui est démarrée (1041) par le biais d'une réinitialisation d'une unité de comptage (CO), des résultats de comparaison livrés par l'unité de comparaison (COMP) sont évalués jusqu'à ce qu'une autre modification d'état d'un résultat de comparaison (AW) soit constatée (1042, 1043) après une première modification d'état d'un résultat de comparaison (AW), et dans lequel alors la période d'évaluation respective prend fin et à l'aide d'une valeur de comptage actuelle (CO_W) de l'unité de comptage (CO) une durée de période et/ou une fréquence d'une partie tension alternative de la tension d'entrée (Uᵣ, U_{rect}) est déterminée (1044).

2. Procédé selon la revendication 1, ***caractérisé en ce que*** pour une détermination d'une valeur moyenne de la tension d'entrée (Uᵣ, U_{rect}) une valeur de somme (U_{r_sum}) de la tension d'entrée (U_{r_dig}) numérisée additionnée sur la période d'évaluation respective ainsi que la valeur de comptage actuelle (CO_W) sont approchées (1044) au niveau d'une fin de la période d'évaluation respective.

3. Procédé selon l'une quelconque des revendications 1 et 2, ***caractérisé en ce que*** pendant une période d'évaluation respective une valeur minimale (U_{r_min}) et une valeur maximale (U_{r_max}) de la tension d'entrée numérisée (U_{r_dig}) sont détectées (1044).

4. Procédé selon l'une quelconque des revendications précédentes, ***caractérisé en ce que*** la tension d'entrée (U_{rect}) est réduite avant le balayage sur une plage de tensions adéquate pour un traitement du signal.

5. Procédé selon l'une quelconque des revendications précédentes, ***caractérisé en ce qu*'**une hystérèse (H) est utilisée (103) par l'unité de comparaison (COMP) lors de la comparaison du signal d'entrée (U_{r_dig}) de l'unité filtrante (PT) avec le signal de sortie (U_{r_pt}) de l'unité filtrante (PT) .

6. Procédé selon l'une quelconque des revendications précédentes, ***caractérisé en ce que*** lorsqu'une valeur de comptage maximale (CO_W) prédéterminée de l'unité de comptage (CO) est atteinte une évaluation du résultat de comparaison (AW) de l'unité de comparaison (COMP) prend fin (1042, 1043).

7. Procédé selon l'une quelconque des revendications précédentes, ***caractérisé en ce que*,** après une numérisation de la tension d'entrée (Uᵣ, U_{rect}) , une réduction de bruit et/ou une suppression de bruit sont exécutées.

8. Système destiné à l'évaluation d'une tension d'entrée (U_{rect}) d'une alimentation à découpage, dans lequel la tension d'entrée (U_{rect}) présente une polarité prédéfinie, ***caractérisé en ce que*** le système présente pour une exécution d'un procédé selon les revendications 1 à 7 au moins les unités fonctionnelles suivantes :
- un convertisseur analogique-numérique (AD) destiné à la numérisation de la tension d'entrée (Uᵣ, U_{rect}), dans lequel la tension d'entrée (Uᵣ, U_{rect}) est balayée avec une fréquence de balayage (CLK) prédéfinie ;
- au moins une unité filtrante (PT) destinée au filtrage de la tension d'entrée numérisée (U_{r_dig}) en tant que signal d'entrée, dans lequel l'unité filtrante (PT) est configurée de telle sorte qu'un signal de sortie (U_{r_pt}) de l'unité filtrante (PT) est en retard par rapport au signal d'entrée (U_{r_dig}) de l'unité filtrante (PT) ;
- une unité de comparaison (COMP) destinée à la comparaison du signal d'entrée (U_{r_dig}) de l'unité filtrante (PT) avec le signal de sortie (U_{r_pt}) de l'unité filtrante (PT) ;
- une unité de comptage (CO) destinée à la mesure d'une période d'évaluation respective, laquelle peut être réinitialisée au début de la période d'évaluation respective ;
- une commande de déroulement (AS), laquelle est conçue pour :
o démarrer une période d'évaluation respective par le biais d'une réinitialisation au moins de l'unité de comptage (CO) ;
o évaluer des résultats de comparaison (AW) livrés par l'unité de comparaison (COMP) jusqu'à ce qu'une autre modification d'état d'un résultat de comparaison (AW) soit constatée après une première modification d'état d'un résultat de comparaison (AW) ;
o mettre fin à une période d'évaluation respective après l'autre changement d'état de sortie de l'unité de comparaison (COMP) et interroger au moins une valeur de comptage actuelle (CO_W) de l'unité de comptage (CO) pour déterminer une durée de période et/ou une fréquence d'une partie tension alternative de la tension d'entrée ; et
- une unité de synchronisation (TI), laquelle prédéfinit par le biais d'une fréquence d'horloge (CLK) une commande temporelle ainsi que la fréquence de balayage (CLK) du convertisseur analogique-numérique (AD).

9. Système selon la revendication 8, ***caractérisé en ce que*,** en outre, une unité d'intégration (INT) destinée à l'addition de la tension d'entrée numérisée (U_{r_dig}) sur la période d'évaluation respective est prévue, dans lequel l'unité d'intégration (INT) peut être réinitialisée au début de la période d'évaluation respective.

10. Système selon l'une quelconque des revendications 8 à 9, ***caractérisé en ce que*,** en outre, une unité de détection (DET) destinée à la détection de valeurs de crête (U_{r_min}, U_{r_max}) de la tension d'entrée numérisée (U_{r_dig}) pendant la période d'évaluation respective est prévue, dans lequel l'unité de détection (DET) peut être réinitialisée au début de la période d'évaluation respective.

11. Système selon l'une quelconque des revendications 8 à 10, ***caractérisé en ce que*** sur un côté entrée du convertisseur analogique-numérique (AD) un diviseur de tension (R1, R2) est disposé, par le biais duquel la tension d'entrée (U_{rect}) peut être réduite à une plage de tensions adéquate pour un traitement du signal.

12. Système selon l'une quelconque des revendications 8 à 11, ***caractérisé en ce que*,** en outre, une autre unité filtrante (PT1) est prévue, laquelle est disposée entre une sortie du convertisseur analogique-numérique (AD) et une entrée de l'unité filtrante (PT).

13. Système selon l'une quelconque des revendications 8 à 12, ***caractérisé en ce que*** le système peut être réalisé à l'aide d'un microcontrôleur ou d'une logique programmable.
